# EUROPEAN PATENT APPLICATION

(11) **EP 2 648 215 A2**
(43) Date of publication of application: **09.10.2013**
(21) Application number: 13161771.4
(22) Date of filing: 28.03.2013
(51) Int. Cl.: H01L 23/00, H01L 21/768, H01L 23/48, H01L 25/065

(54) **Method and apparatus providing integrated circuit system with interconnected stacked device wafers**

(30) Priority: 06.04.2012 US 201213441627
(71) Applicant: OmniVision Technologies, Inc., Santa Clara, CA 95054 (US)
(72) Inventor: Qian, Yin, Milpitas, CA California 95035 (US); Tai, Hsin-Chih, San Jose, CA California 95129 (US); Mao, Duli, Sunnyvale, CA California 94087 (US); Dai, Tiejun, Santa Clara, CA California 95051 (US); Rhodes, Howard E., San Martin, CA California 95046 (US); Yang, Hongli, Saratoga, CA California 95070 (US)
(74) Representative: Hackney, Nigel John

(57) **Abstract**

An integrated circuit system includes a first device wafer that has a first semiconductor layer proximate to a first metal layer including a first conductor disposed within a first metal layer oxide. A second device wafer that has a second semiconductor layer proximate to a second metal layer including a second conductor disposed within a second metal layer oxide is also included. A frontside of the first metal layer oxide is bonded to a frontside of the second metal layer oxide at an oxide bonding interface between the first metal layer oxide and the second metal layer oxide. A conductive path couples the first conductor to the second conductor with conductive material formed in a cavity etched between the first conductor and the second conductor and etched through the oxide bonding interface and through the second semiconductor layer from a backside of the second device wafer.

## Description

### BACKGROUND INFORMATION

### Field of the Disclosure

The present invention relates generally semiconductor processing. More specifically, embodiments of the present invention are related to semiconductor processing of stacked integrated circuit systems.

### Background

As integrated circuit technologies continue to advance, there are continuing efforts to increase performance and density, improve form factor, and reduce costs. The implementation of stacked three dimensional integrated circuits have been one approach that designers sometimes use to realize these benefits. Some examples of where three dimensional integrated circuits are a suitable consideration include stacking memory on top of image sensors or processor chips, stacking memory on top of processor chips, stacking processor chips on top of image sensors, stacking chips that are fabricated with different fabrication processes, stacking two small integrated circuit chips whose separate yield may be higher than one large one, or stacking chips to reduce the integrated circuit system footprint.

A key challenge to implementing stacked three dimensional integrated circuits is how to make many small area interconnects between the integrated circuit chips with high yield and reliability. For example, the typical copper-to-copper bonds between the stacked integrated circuit chips often suffer from wafer warpage as well as bow. Furthermore, the copper surface roughness and non-planarity present additional challenges when trying to provide connections between the integrated circuit chips. Other known techniques for making the many small area interconnects between the stacked integrated circuit chips are also expensive, unreliable and large.

### BRIEF DESCRIPTION OF THE DRAWINGS

Non-limiting and non-exhaustive embodiments of the present invention are described with reference to the following figures, wherein like reference numerals refer to like parts throughout the various views unless otherwise specified.

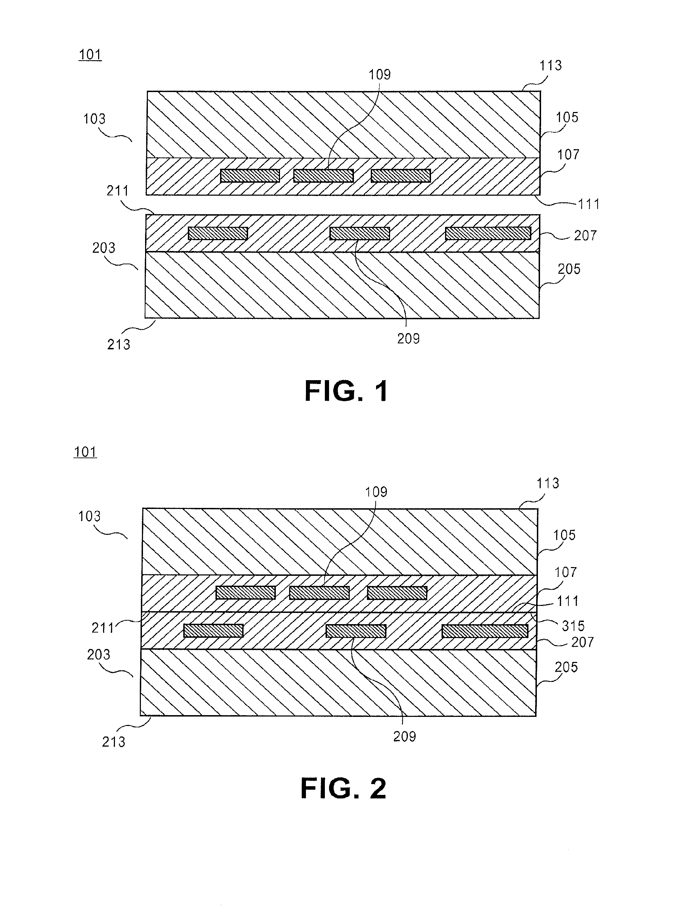

**FIG. 1** is a cross-section diagram illustrating one example of first and second device wafers that may be included in an example integrated circuit system accordance with the teachings of the present invention.

**FIG. 2** is a cross-section diagram illustrating one example of first and second device wafers that are stacked and bonded together in an example integrated circuit system accordance with the teachings of the present invention.

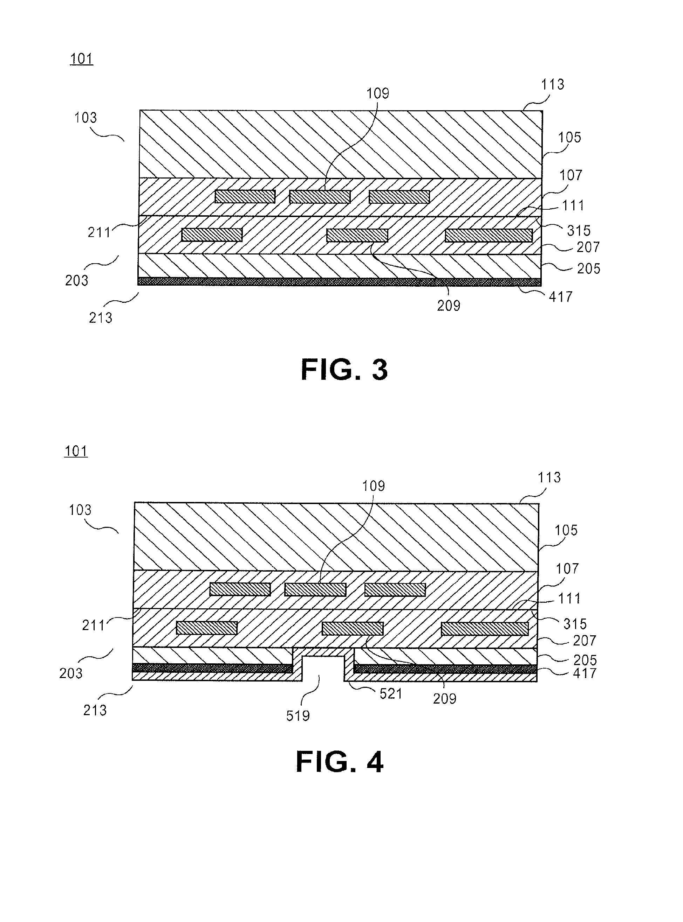

**FIG. 3** is a cross-section diagram illustrating one example of stacked and bonded first and second device wafers with one of the wafers having a thinned and passivated semiconductor layer in an example integrated circuit system accordance with the teachings of the present invention.

**FIG. 4** is a cross-section diagram illustrating one example of stacked and bonded first and second device wafers with an oxide deposition over an etched opening through the of one of the semiconductor layers in an example integrated circuit system accordance with the teachings of the present invention.

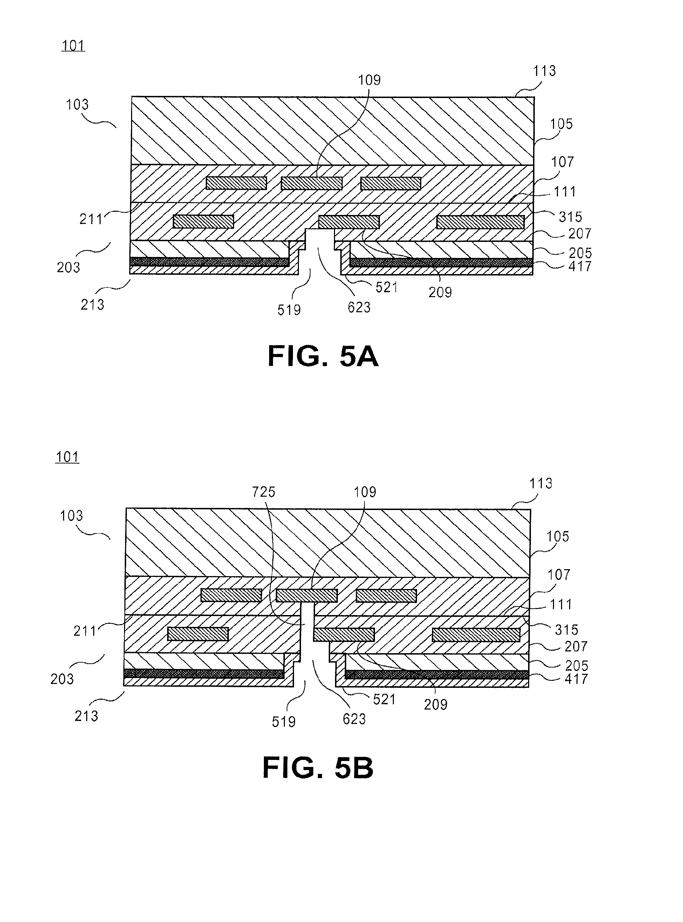

**FIG. 5A** is a cross-section diagram illustrating one example of stacked and bonded first and second device wafers with a trench etched with a first mask in an opening through one of the semiconductor layers to a conductor in an example integrated circuit system accordance with the teachings of the present invention.

**FIG. 5B** is a cross-section diagram illustrating one example of stacked and bonded first and second device wafers with a cavity etched in the trench with a second mask between first and second conductors and etched through a bonding interface and through one of the semiconductor layers from a backside of one of the device wafers in an example integrated circuit system accordance with the teachings of the present invention.

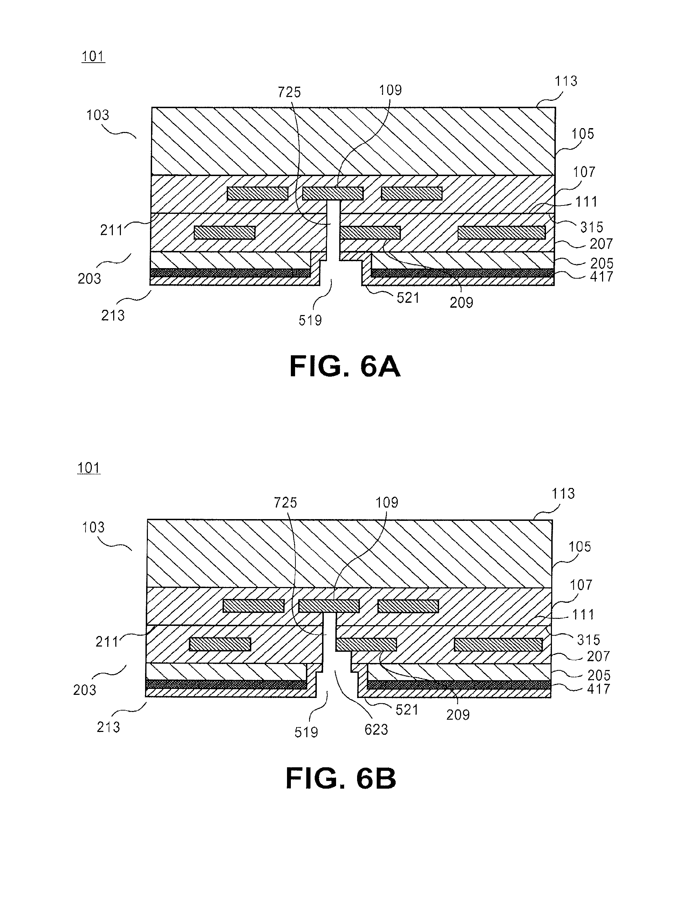

**FIG. 6A** is a cross-section diagram illustrating another example of stacked and bonded first and second device wafers with a cavity etched with a first mask between first and second conductors and etched through a bonding interface and through one of the semiconductor layers from a backside of one of the device wafers in an example integrated circuit system accordance with the teachings of the present invention.

**FIG. 6B** is a cross-section diagram illustrating another example of stacked and bonded first and second device wafers with a trench etched over the cavity with a second mask in an opening through one of the semiconductor layers to a conductor in an example integrated circuit system accordance with the teachings of the present invention.

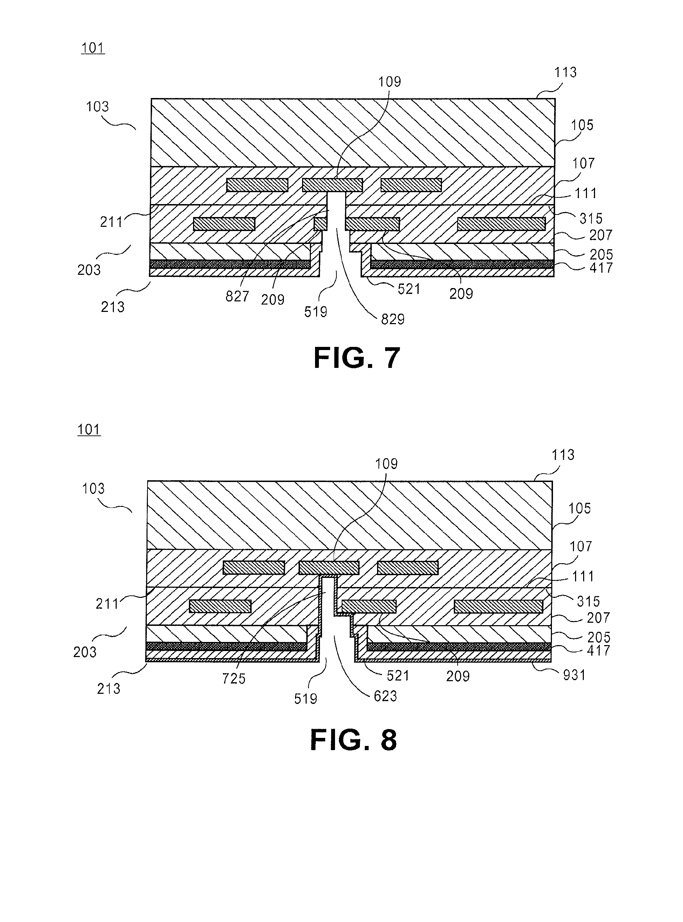

**FIG. 7** is a cross-section diagram illustrating yet another example of stacked and bonded first and second device wafers with a cavity etched with a single mask between first and second conductors and etched through a donut hole in one of the conductors, through a bonding interface and through one of the semiconductor layers from a backside of one of the device wafers in an example integrated circuit system accordance with the teachings of the present invention.

**FIG. 8** is a cross-section diagram illustrating one example of stacked and bonded first and second device wafers with a barrier metal deposition over the backside and a cavity etched between first and second conductors from a backside of one of the device wafers in an example integrated circuit system accordance with the teachings of the present invention.

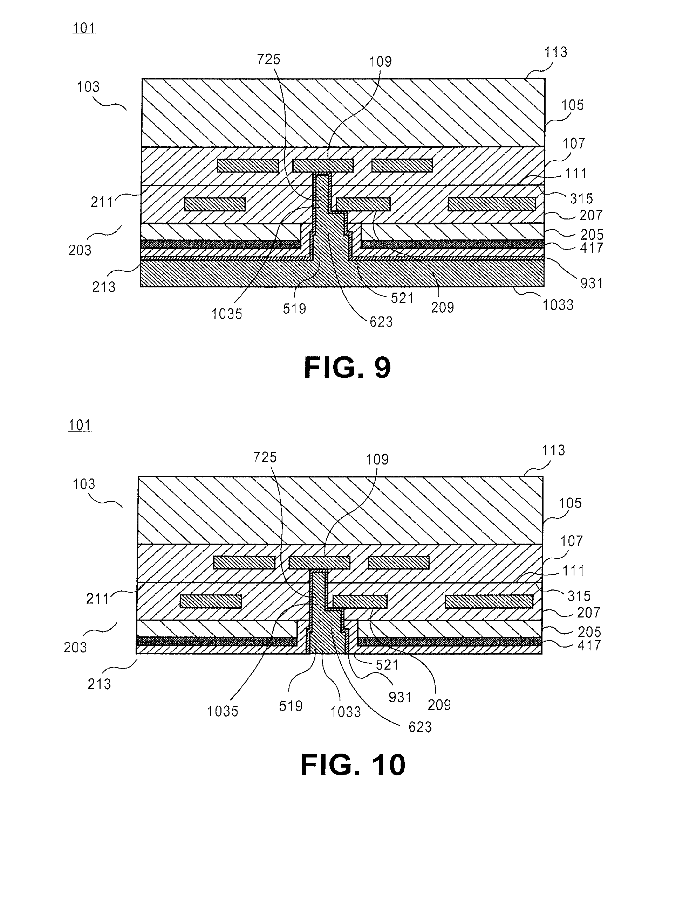

**FIG. 9** is a cross-section diagram illustrating one example of stacked and bonded first and second device wafers with a cavity etched between first and second conductors from a backside of one of the device wafers filled with conductive material to provide a conductive path between the first and second conductors in an example integrated circuit system accordance with the teachings of the present invention.

**FIG. 10** is a cross-section diagram illustrating one example of stacked and bonded first and second device wafers with the conductive material providing the conductive path between the first and second conductors etched and polished in an example integrated circuit system accordance with the teachings of the present invention.

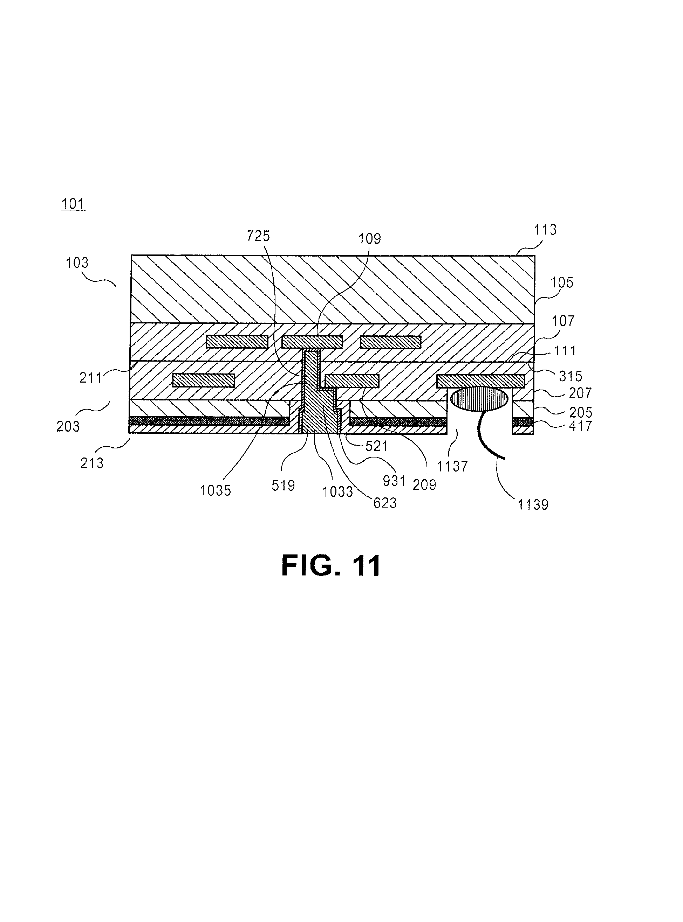

**FIG. 11** is a cross-section diagram illustrating one example of stacked and bonded first and second device wafers with a wire bond cavity and wire bond in an example integrated circuit system accordance with the teachings of the present invention.

### DETAILED DESCRIPTION

As will be shown, examples of a method and apparatus providing an integrated circuit system with stacked integrated circuit device wafers using one or more conductive paths between conductors in respective metal layer oxides through a bonding interface are disclosed. In the following description, numerous specific details are set forth in order to provide a thorough understanding of the present invention. It will be apparent, however, to one having ordinary skill in the art that the specific detail need not be employed to practice the present invention. In other instances, well-known materials or methods have not been described in detail in order to avoid obscuring the present invention.

Reference throughout this specification to "one embodiment", "an embodiment", "one example" or "an example" means that a particular feature, structure or characteristic described in connection with the embodiment or example is included in at least one embodiment of the present invention. Thus, appearances of the phrases "in one embodiment", "in an embodiment", "one example" or "an example" in various places throughout this specification are not necessarily all referring to the same embodiment or example. Furthermore, the particular features, structures or characteristics may be combined in any suitable combinations and/or subcombinations in one or more embodiments or examples. Particular features, structures or characteristics may be included in an integrated circuit, an electronic circuit, a combinational logic circuit, or other suitable components that provide the described functionality. In addition, it is appreciated that the figures provided herewith are for explanation purposes to persons ordinarily skilled in the art and that the drawings are not necessarily drawn to scale.

To illustrate, **FIG. 1** is a cross-section diagram illustrating one example of a first device wafer 103 and a second device wafer 203 that are included in one example of an integrated circuit system 101 in accordance with the teachings of the present invention. In one example, one of first device wafer 103 and second device wafer 203 may be an imager chip, an application specific integrated circuit, or the like, and the other one of first device wafer 103 and second device wafer 203 may be a processing chip, an application specific integrated circuit, or the like.

As shown in the example, first device wafer 103 includes a first semiconductor layer 105 proximate to a first metal layer including a first conductor 109 disposed within a first metal layer oxide 107. In the depicted example, first metal layer oxide 107 is proximate to a frontside 111 of first device wafer 103 and first semiconductor layer 105 is proximate to a backside 113 of first device wafer 103. In one example, first semiconductor layer 105 includes silicon.

Continuing with the example depicted in **FIG. 1****,** second device wafer 203 includes a second semiconductor layer 205 proximate to a second metal layer including a second conductor 209 disposed within a second metal layer oxide 207. In the depicted example, second metal layer oxide 207 is proximate to a frontside 211 of second device wafer 203 and second semiconductor layer 205 is proximate to a backside 213 of second device wafer 203. In one example, second semiconductor layer 205 includes silicon.

In one example, at least one of frontside 111 of first metal layer oxide 107 and frontside 211 of the second metal layer oxide 207 is flattened by a chemical mechanical polish.

**FIG. 2** is a cross-section diagram that illustrates integrated circuit system 101 with first device wafer 103 bonded to second device wafer 203. As shown in the depicted example, frontside 111 of the first metal layer oxide 107 of the first device wafer 103 is bonded to frontside 211 of the second metal layer oxide 207 of the second device wafer 203 at a bonding interface 315 between first metal layer oxide 107 and second metal layer oxide 207 in accordance with the teachings of the present invention.

In the example illustrated in **FIG. 2**, it is noted that all of the conductors including first conductor 109 of the first metal layer within first metal layer oxide 107 are illustrated beneath the frontside 111 surface of first device wafer 103. Similarly, it is noted that all of the conductors including second conductor 209 of the second metal layer within second metal layer oxide 207 are illustrated beneath the frontside 211 surface of second device wafer 203. Therefore, in the depicted example, bonding interface 315 includes an oxide-to-oxide bonding between first metal layer oxide 107 and second metal layer oxide 207. In another example, it is appreciated that if one of the metal layers includes conductors that are flush with surface of frontside 111 or frontside 211, then the bonding interface 315 may be an oxide-to-conductor interface. However, in either example, at least one of the surfaces at bonding interface 315 includes the oxide of first metal layer oxide 107 and/or second metal layer oxide 207 in accordance with the teachings of the present invention. Therefore, in one example, bonding interface 315 is an oxide bonding interface in accordance with the teachings of the present invention.

**FIG. 3** is a cross-section diagram that illustrates an example of integrated circuit system 101 with stacked and bonded first device wafer 103 and second device wafer 203 as discussed above, and with second device wafer 203 having a thinned second semiconductor layer 205. In one example, after second semiconductor layer 205 is thinned from backside 213 as illustrated, second semiconductor layer 205 is then passivated as shown to form a passivation layer 417 on thinned second semiconductor layer 205 in accordance with the teachings of the present invention.

**FIG. 4** is a cross-section diagram that illustrates an example of integrated circuit system 101 with stacked and bonded first device wafer 103 and second device wafer 203, and second semiconductor layer 205 thinned and passivated as discussed above. In addition, the example depicted in **FIG. 4** shows an opening 519 etched from backside 213 of second device wafer 203 through second semiconductor layer 205. In one example, opening 519 is etched from backside 213 through second semiconductor layer 205 to second metal layer oxide 207 as shown.

Continuing with the illustrated example, **FIG. 4** also shows that after opening 519 is etched through second semiconductor layer 205 to second metal layer oxide 207, an oxide deposition 521 is deposited on backside 213 and over opening 519 of second device wafer 203 as shown.

**FIG. 5A** is a cross-section diagram illustrating one example of an example of integrated circuit system 101 with etched opening 519 through second semiconductor layer 205 covered with oxide deposition 521 as discussed above in **FIGs. 1-4**. In addition, **FIG. 5A** illustrates an example in which a trench 623 is then etched in opening 519 from backside 213 through oxide deposition 521 and through second metal layer oxide 207 to second conductor 209 as shown. In one example, trench 623 is etched as described from backside 213 using a first mask.

**FIG. 5B** continues from the example depicted above in **FIG. 5A** in which trench 623 is etched in opening 519 from backside 213 through oxide deposition 521 and through second metal layer oxide 207 to second conductor 209. In the example depicted in **FIG. 5B****,** a cavity 725 is then etched through trench 623 from backside 213 of the second semiconductor layer 205 and through bonding interface 315 to first conductor 109 within first metal layer oxide 107 as shown in accordance with the teachings of the present invention. In one example, cavity 725 is etched as described from backside 213 using a second mask.

**FIG. 6A** is a cross-section diagram illustrating another example of an example of integrated circuit system 101 with etched opening 519 through second semiconductor layer 205 covered with oxide deposition 521 as discussed above in **FIGs. 1-4**. In addition, **FIG. 6A** illustrates an example in which cavity 725 is etched in opening 519 from backside 213 through oxide deposition 521, through second metal layer oxide 207 and through bonding interface 315 to first conductor 109 within first metal layer oxide 107 as shown. In one example, cavity 725 is etched as described from backside 213 using a first mask.

**FIG. 6B** continues from the example depicted above in **FIG. 6A** in which cavity 725 is etched in opening 519 from backside 213 through oxide deposition 521 and through second metal layer oxide 207 to first conductor 109 within first metal layer oxide 107. In the example depicted in **FIG. 6B****,** trench 623 is then etched over cavity 725 from backside 213 through oxide deposition 521 and through second metal layer oxide 207 to second conductor 209 as shown in accordance with the teachings of the present invention. In one example, trench 623 is etched as described from backside 213 using a second mask.

**FIG. 7** is a cross-section diagram illustrating still another example of an example of integrated circuit system 101 with etched opening 519 through second semiconductor layer 205 covered with oxide deposition 521 as discussed above in **FIGs. 1-4****.** In addition, **FIG. 7** illustrates an example in which second conductor 209 includes a donut hole 829 or other suitable opening through which a cavity can be etched. For instance, in the example depicted in **FIG. 7****,** a cavity 827 is etched in opening 519 from backside 213 through oxide deposition 521, through second metal layer oxide 207, through donut hole 829 of second conductor 209 and through bonding interface 315 to first conductor 109 within first metal layer oxide 107 as shown. In one example, cavity 827 is etched as described from backside 213 using a single mask.

**FIG. 8** is a cross-section diagram that illustrates an example of integrated circuit system 101 as described in the examples above in which a cavity is etched between first conductor 109 and second conductor 209 from backside 213 through oxide deposition 521, through second metal layer oxide 207 and through bonding interface 315. In addition, **FIG. 8** illustrates a barrier metal deposition 931 deposited from backside 213 over oxide deposition 521 and over the walls of trench 623, and cavity 725 covering exposed portions of first conductor 109, second conductor 209, first metal layer oxide 107 and second metal layer oxide 207 in accordance with the teachings of the present invention.

**FIG. 9** is a cross-section diagram that continues with the example integrated circuit system 101 as described above in which barrier metal deposition 931 is deposited from backside 213 over oxide deposition 521 and over the walls of trench 623 and cavity 725. In addition, **FIG. 9** illustrates that cavity 725, trench 623 and opening 519 are filled from backside 213 with a conductive material 1033. Accordingly, a conductive path 1035 coupling first conductor 109 and second conductor 209 is now provided with conductive material 1033 formed in cavity 725 in accordance with the teachings of the present invention. Thus, first conductor 109 is coupled to second conductor 209 through conductive path 1035 and through barrier metal deposition 931.

**FIG. 10** is a cross-section diagram that continues with the example integrated circuit system 101 as described above in which cavity 725, trench 623 and opening 519 are filled with conductive material 1033 from backside 213 to provide conductive path 1035 between first conductor 109 and second conductor 209. In addition, **FIG. 10** shows an example of backside 213 of second device wafer 203 after being etched and/or polished down to oxide deposition 521 as shown, which removes excess conductive material 1033 from backside 213 in accordance with the teachings of the present invention.

**FIG. 11** is a cross-section diagram that continues with the example integrated circuit system 101 as described above in which backside 213 of second device wafer 203 is etched and/or polished down to oxide deposition 521 removing excess conductive material 1033 from backside 213. In addition, **FIG. 11** illustrates an example in which a wire bond cavity 1137 and a wire bond 1139 are formed to provide a package connection to a conductor in second metal layer oxide 207 in an example integrated circuit system 101 in accordance with the teachings of the present invention.

The above description of illustrated examples of the present invention, including what is described in the Abstract, are not intended to be exhaustive or to be limitation to the precise forms disclosed. While specific embodiments of, and examples for, the invention are described herein for illustrative purposes, various equivalent modifications are possible without departing from the broader spirit and scope of the present invention. Indeed, it is appreciated that the specific example voltages, currents, frequencies, power range values, times, etc., are provided for explanation purposes and that other values may also be employed in other embodiments and examples in accordance with the teachings of the present invention.

These modifications can be made to examples of the invention in light of the above detailed description. The terms used in the following claims should not be construed to limit the invention to the specific embodiments disclosed in the specification and the claims. Rather, the scope is to be determined entirely by the following claims, which are to be construed in accordance with established doctrines of claim interpretation. The present specification and figures are accordingly to be regarded as illustrative rather than restrictive.

## Claims

1. An integrated circuit system, comprising:
a first device wafer having a first semiconductor layer proximate to a first metal layer including a first conductor disposed within a first metal layer oxide;
a second device wafer having a second semiconductor layer proximate to a second metal layer including a second conductor disposed within a second metal layer oxide, wherein a front side of the first metal layer oxide of the first device wafer is bonded to a front side of the second metal layer oxide of the second device wafer at a bonding interface between the first metal layer oxide and the second metal layer oxide; and
a conductive path coupling the first conductor to the second conductor, wherein the conductive path is provided with conductive material formed in a cavity etched between the first conductor and the second conductor and etched through the bonding interface and through the second semiconductor layer from a backside of the second device wafer.

2. The integrated circuit system of claim 1 further comprising a barrier metal deposition deposited in the cavity between the conductive path and the first conductor and the second conductor, wherein the first conductor is coupled to the second conductor through the barrier metal deposition and the conductive path.

3. The integrated circuit system of any of the above claims further comprising an oxide deposition disposed between the conductive material and the second semiconductor layer.

4. The integrated circuit system of claim 3 further comprising a passivation layer disposed between the backside of the second semiconductor layer and the oxide deposition.

5. The integrated circuit system of any of the above claims wherein at least one of the front side of the first metal layer oxide and the front side of the second metal layer oxide is flattened by a chemical mechanical polish.

6. A method of fabricating an integrated circuit system, comprising
forming a first conductor in a first metal layer disposed within a first metal layer oxide proximate to a first semiconductor layer of a first device wafer;
forming a second conductor in a second metal layer disposed within a second metal layer oxide proximate to a second semiconductor layer of a second device wafer;
bonding a frontside of the first metal layer oxide of the first device wafer to a frontside of the second metal layer oxide of the second device wafer at a bonding interface between the first metal layer oxide and the second metal layer oxide;
etching a cavity between the first conductor and the second conductor and through the bonding interface and through the second semiconductor layer from a backside of the second device wafer; and
filling the cavity with conductive material to provide a conductive path coupling the first conductor to the second conductor.

7. The method of claim 6 further comprising depositing a barrier metal deposition in the cavity prior to filling the cavity with the conductive material to provide the conductive path coupling the first conductor to the second conductor.

8. The method of claim 6 or 7 further comprising passivating the backside of the second device wafer prior to etching the cavity between the first conductor and the second conductor.

9. The method of any of claims 6-8 further comprising depositing an oxide deposition on the backside of the second device wafer prior to etching the cavity between the first conductor and the second conductor.

10. The method of any of claims 6-9further comprising flattening at least one of the frontside of the first metal layer oxide and the frontside of the second metal layer oxide by chemical mechanical polishing prior to bonding the frontside of the first metal layer oxide of the first device wafer to the frontside of the second metal layer oxide of the second device wafer.

11. The integrated circuit system of any of any of claims 1-5 or the method of any of claims 6-10 wherein the second semiconductor layer through which the cavity is etched is thinned prior to etching of the cavity.

12. The integrated circuit system of any of claims 1-5 or 11 or the method of any of claims 6-11 wherein the cavity is further etched through a donut hole in the second conductor.

13. The integrated circuit system of any of claims 1-5 or 11-12 or the method of any of claims 6-12 wherein the cavity is further etched through a trench etched from the backside of the second semiconductor layer to the first conductor.

14. The integrated circuit system of any of claims 1-5 or 11-13 or the method of any of claims 6-13 wherein the cavity is etched prior to etching the trench from the backside of the second semiconductor layer to the first conductor.

15. The integrated circuit system of any of claims 1-5 or 11-14 or the method of any of claims 6-14 wherein one of the first device wafer and second device wafer comprises an imager chip and another one of the first device wafer and second device wafer comprises a processing chip.
